(19) **Europäisches Patentamt / European Patent Office / Office européen des brevets**

(11) **EP 4 382 929 B1**

(12) # EUROPEAN PATENT SPECIFICATION

(45) Date of publication and mention
of the grant of the patent:
**10.12.2025   Bulletin 2025/50**

(21) Application number: **21952667.0**

(22) Date of filing: **04.08.2021**

(51) International Patent Classification (IPC):
*G01R 31/36* (2020.01)     *H01M 10/48* (2006.01)
*G01R 31/388* (2019.01)    *G01R 31/367* (2019.01)
*G01R 31/389* (2019.01)    *G01R 31/392* (2019.01)

(52) Cooperative Patent Classification (CPC):
**H01M 10/48; G01R 31/367; G01R 31/388;
G01R 31/389; G01R 31/392**

(86) International application number:
**PCT/ES2021/070590**

(87) International publication number:
**WO 2023/012383 (09.02.2023 Gazette 2023/06)**

(54) **METHOD FOR CHARACTERISING BATTERIES**

VERFAHREN ZUR CHARAKTERISIERUNG VON BATTERIEN

PROCÉDÉ DE CARACTÉRISATION DE BATTERIES

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**12.06.2024   Bulletin 2024/24**

(73) Proprietors:
• **Beeplanet Factory, S.L.
31110 Noain (ES)**
• **UNIVERSIDAD PUBLICA DE NAVARRA
31006 Pamplona (ES)**

(72) Inventors:
• **SAN MARTÍN BIURRUN, Idoia
31006 Pamplona (ES)**
• **BRACO SOLA, Elisa
31610 Villava (ES)**
• **BERRUETA IRIGOYEN, Alberto
31006 Pamplona (ES)**
• **SOTO CABRIA, Adrián
01007 Vitoria-Gasteiz (ES)**
• **IRIBARREN ZABALEGUI, Álvaro
31008 Pamplona (ES)**
• **SANCHÍS GÚRPIDE, Pablo
31016 Pamplona (ES)**
• **URSÚA RUBIO, Alfredo
31016 Pamplona (ES)**

• **ASIN MUÑOA, Jon
31110 Noain (ES)**
• **LARREA LEÓN, Carlos
31110 Noain (ES)**
• **CARLO ESCUDERO, Javier
31110 Noain (ES)**
• **URRIZBURU SANTOS, Alfonso
31110 Noain (ES)**
• **PUEYO RUFAS, Carlos
31110 Noain (ES)**

(74) Representative: **Isern Patentes y Marcas S.L.
Avda. Diagonal, 463 Bis, 2°
08036 Barcelona (ES)**

(56) References cited:
• STROE ANA-IRINA ET AL: "Performance model
for high-power lithium titanate oxide batteries
based on extended characterization tests", 2015
IEEE ENERGY CONVERSION CONGRESS AND
EXPOSITION (ECCE), IEEE, 20 September 2015
(2015-09-20), pages 6191 - 6198, XP032801417,
DOI: 10.1109/ECCE.2015.7310528

**(Cont. next page)**

- NEJAD S ET AL: "A systematic review of lumped-parameter equivalent circuit models for real-time estimation of lithium-ion battery states", JOURNAL OF POWER SOURCES, ELSEVIER, AMSTERDAM, NL, vol. 316, 4 April 2016 (2016-04-04), pages 183 - 196, XP029506275, ISSN: 0378-7753, DOI: 10.1016/ J.JPOWSOUR.2016.03.042
- ABDEL-MONEM MOHAMED; HEGAZY OMAR; OMAR NOSHIN; TRAD KHIEM; VAN DEN BOSSCHE PETER; VAN MIERLO JOERI: "Lithium-ion batteries: Comprehensive technical analysis of second-life batteries for smart grid applications", 2017 19TH EUROPEAN CONFERENCE ON POWER ELECTRONICS AND APPLICATIONS (EPE&APOS;17 ECCE EUROPE), JOINTLY OWNED IEEE-PELS AND EPE ASSOCIATION, 11 September 2017 (2017-09-11), XP033250767, DOI: 10.23919/ EPE17ECCEEurope.2017.8099385
- STROE DANIEL-IOAN, SWIERCZYNSKI MACIEJ, STROE ANA-IRINA, KNUDSEN KÆR SØREN: "Generalized Characterization Methodology for Performance Modelling of Lithium-Ion Batteries", BATTERIES, vol. 2, no. 4, pages 37, XP093032514, DOI: 10.3390/batteries2040037
- LOCOROTONDO, EDOARDO ET AL.: "Electrical lithium battery performance model for second life applications", 2020 IEEE INTERNATIONAL CONFERENCE ON ENVIRONMENT AND ELECTRICAL ENGINEERING AND 2020 IEEE INDUSTRIAL AND COMMERCIAL POWER SYSTEMS EUROPE (EEEIC/I&CPS EUROPE, 2020, pages 1 - 6, XP033801564, DOI: 10.1109/ EEEIC/ICPSEurope49358.2020.9160496
- MUHAMMAD, MUSBAHU ET AL.: "Assessment of spent EV batteries for second-life application", 2019 IEEE 4TH INTERNATIONAL FUTURE ENERGY ELECTRONICS CONFERENCE (IFEEC, 2019, pages 1 - 5, XP033727944, DOI: 10.1109/ IFEEC47410.2019.9015015
- MARTINEZ-LASERNA EGOITZ, SARASKETA-ZABALA ELIXABET, VILLARREAL SARRIA IGOR, STROE DANIEL-IOAN, SWIERCZYNSKI MACIEJ, WARNECKE ALEXA: "Technical Viability of Battery Second Life: A Study From the Ageing Perspective", IEEE TRANSACTIONS ON INDUSTRY APPLICATIONS., IEEE SERVICE CENTER, PISCATAWAY, NJ., US, vol. 54, no. 3, 27 December 2017 (2017-12-27), US , pages 2703 - 2713, XP093032511, ISSN: 0093-9994, DOI: 10.1109/TIA.2018.2801262

## Description

### Technical field of the invention

The present invention can be included within the field of electric batteries. In particular, the object of the present invention relates to a method that allows the capacity and internal resistance of batteries, generally lithium batteries, to be rapidly determined for the reuse thereof for a second life.

### Background of the invention

The capacity and internal resistance of a battery (or of a cell, the basic unit that makes up a battery) are the main indicators of its state of health. In certain industrial sectors (for example, the reuse of batteries for a second life), it is of paramount importance to know the capacity and internal resistance of the cells with the double aim of building batteries with cells that are as similar as possible and to be able to estimate the durability thereof in the second-life application to offer the best possible guarantee. In this sense, the characterisation of a battery removed from an electric vehicle is essential to ensure correct operation in its second life. Despite the fact that regulations establish the permitted value with regard to loss of capacity in batteries used in electric vehicles, the actual capacity at the beginning of the second life may vary, for example due to different aging rates of the cells during their first life in the electric vehicle. This implies that all removed batteries must be characterised before their second life to certify that they meet the requirements of the application. Moreover, knowledge of the internal features of the batteries for their second life represents an advantage if they are to be reused on a modular level, since it allows the internal dispersion of the battery to be reduced in the second life, guaranteeing a suitable operation and homogeneous aging that contributes to extending its useful life and, consequently, ensuring its profitability.

The measurement, both of capacity and internal resistance, is not a trivial process, but rather different compromises can be established between accuracy, reliability, cost of the equipment and time required for the measurement (and therefore labour cost and energy consumption).

Traditional characterisation methods consist of multi-hour tests based on full charges and discharges to obtain the capacity, as well as electrochemical impedance spectroscopy (EIS), or step current, to measure internal impedance. Despite the fact that these methods allow the internal parameters to be accurately known, the time and infrastructure required to carry them out currently represent a significant barrier to the reduction of the costs of the process required for reusing batteries, and therefore also a barrier to its market penetration.

The traditional way of measuring the capacity of lithium-ion cells, modules or batteries consists of performing a certain number of complete charge and discharge cycles at a certain current level and, if high accuracy is desired, controlling the temperature of the test. This test lasts approximately 6 to 8 hours for each charge-discharge cycle. Typically, between 3 and 5 cycles are performed, such that the test can last between 18 and 40 hours. Regarding the measurement of internal resistance, this parameter varies depending on the state of charge (SOC) of the battery. The traditional way of measuring resistance at a specific SOC value consists of charging or discharging the charge percentage required to reach the desired SOC from the cell, module or battery, and then performing a step current while measuring the voltage and current. The process of reaching the desired SOC can take between 0 minutes (if the cell is exactly at that SOC) and 2 hours, if the reception SOC of the cell is very far from that to be had, and depending on the discharge current. If an accurate measurement is desired, the control of the test temperature is also required. Given the importance of characterising second-life batteries to guarantee the economic and technical viability thereof, and the lack of methods that combine simplicity and speed, a novel approach is sought to estimate the internal features that define the state of second life batteries, based on experimental measurements lasting a few seconds.

STROE ANA-IRINA ET AL: "Performance model for high-power lithium titanate oxide batteries based on extended characterization tests",2015 IEEE ENERGY CONVERSION CONGRESS AND EXPOSITION (ECCE), IEEE, 20 September 2015 (2015-09-20), pages 6191-6198,DOI: 10.1109/ECCE.2015.7310528 discloses a method for characterising a battery based on the battery impedance at a predetermined frequency and on a discharge resistance at a predetermined state of charge.

### Summarised description of the invention

The present invention describes a method for characterising batteries, as explained below.

In summary, the present invention aims to determine the capacity and internal resistance of each of the batteries (cells, modules, or battery packs) of a new battery pack, based on a previous global characterisation of a prior battery pack to which the former is sufficiently similar, with a prior affinity check.

The main part of the method consists of a simplified characterisation, lasting approximately 30 seconds to 2 minutes, with a simplified test method and equipment. The simplified characterisation is performed on all batteries, cells, modules or battery packs the features of which are to be known, obtaining, for each of said batteries, simplified characterisation parameters, from which the capacity and internal resistance of the battery are calculated by means of one or more pre-established mathematical models. In the present invention, three mathematical models have been developed, representing different compromises between the simplicity of the tests and the accuracy achieved.

The mathematical methods depend on a series of model parameters, the prior determination of which is carried out by means of a detailed characterisation of a battery pack (cells, modules, battery packs), which takes approximately 12 hours. Detailed characterisation comprises subjecting the batteries to certain tests and measurements to obtain detailed characterisation parameters, which are used to adjust (for example, using least squares adjustment) the model parameters of the battery pack. In principle, a greater number of elements (cells, modules, battery packs) in the sample subjected to the detailed characterisation will imply greater accuracy. However, from a certain maximum number, which depends on each sample, in particular, on the dispersion of each sample, an improvement in accuracy that compensates for the increase in resources is not obtained. Having determined the model parameters for each of the models, all the coefficients of the models are defined, which allows the capacity (C^) and the internal resistance ($R_{DC\_SOC}$) to be estimated, applying the simplified characterisation parameters obtained in the aforementioned simplified characterisation to the models, as long as the features of the batteries (cells, modules, battery packs) are sufficiently similar to those of the batteries used in the detailed characterisation, as explained below.

In relation to the previous paragraph, the invention also relates to a statistical analysis involving the simplified characterisation parameters and the detailed characterisation parameters, to determine if the cells to be characterised are sufficiently similar to any of the packs previously characterised using a detailed characterisation, and therefore, they can be characterised by applying the models determined for said pack, or if, on the contrary, the detailed characterisation for the battery pack received must be carried out.

The proposed method has two fundamental advantages over the traditional one:

- Reduction of testing time. Once the detailed characterisation of a population is available, the tests that allow the capacity and internal resistance at any SOC level of each cell to be estimated last between 30 seconds and 2 minutes, compared to the hours-long traditional method.
- **Less need** for testing equipment. There is no longer a need to control the temperature and the use of cell (and/or module and/or battery pack) cycling equipment is drastically reduced, since they are only required in the phase of detailed characterisation of a population.

The general features of simplified characterisation, detailed characterisation and statistical analysis which define the present invention, are described below.

SIMPLIFIED CHARACTERISATION

Simplified characterisation involves taking each of the batteries from the new pack to be characterised and obtaining the simplified characterisation parameters thereof, to introduce them into one or several predetermined models that allow the capacity (C^), as well as the internal resistance ($R_{DC\_SOC}$) to be estimated based on the state of charge (SOC) of each battery.

The simplified characterisation requires simple equipment, including: a voltmeter, ammeter, impedance meter (for example, at 1 kHz), and a current-controllable power source capable of withstanding a current of C/2 (in accordance with regulations) or, alternatively to the power source, a resistance that allows the battery to be discharged with the desired current. With the indicated equipment, simplified characterisation parameters are obtained, as will be explained below, which are: open-circuit voltage (Voc), impedance ($R_{AC}$), and resistance (in conditions) of discharge ($R_{DC0}$).

The steps of an exemplary simplified characterisation are described below:

1- Measuring open-circuit voltage ($V_{OC}$) in the battery at the initial SOC. From the value of $V_{OC}$, and through a predetermined relationship $V_{OC}$-FSOC an FSOC value is obtained. The $V_{OC}$ - FSOC relationship is determined via the state of charge (SOC), such that SOC is first obtained from $V_{OC}$, and then FSOC is obtained from SOC. Wherein the SOC-FSOC relationship may either be general for any model or set of models, or it may be specifically predetermined for the model or model pack being used.

2- Measuring impedance ($R_{AC}$) of the battery at a predetermined frequency, such as 1 kHz, by means of the impedance meter. In particular, the determination of $R_{AC}$ can be done by introducing a sinusoidal disturbance into the battery, at a frequency of 1 kHz, by means of the impedance meter. This disturbance can be in the form of current ($\tilde{\imath}$) or voltage ($\tilde{v}$), and the complementary variable (voltage if the disturbance is current, or current if the disturbance is voltage) is measured. The same impedance meter calculates $R_{AC}$ as $R_{AC} = \dfrac{\tilde{v}}{\tilde{\imath}}$ in any event.

3- Measuring discharge resistance ($R_{DC0}$), subjecting the battery to a step discharge current by means of the aforementioned power source or resistor, for example, current c/2 with a predetermined duration (for example, 10 s.) Before the step discharge, voltage (V1) is measured with the voltmeter, and current (I1) is measured with the ammeter. After the step discharge, the voltage (V2) and current (I2) are measured again to determine the discharge resistance $R_{DC0}$ = (V2-V1) / (I2-I1).

4- From $R_{DC0}$ and from FSOC, see point 1, $R_{DC30}$ is determined as $R_{DC30}$ =FSOC * $R_{DC0}$. $R_{DC\_30}$ is measured instead of $R_{DC0}$ to take into account the following two factors that affect the impedance of a battery:

- The SOC of the cell at the time of measurement; and
- The effect of the inactivity of the cell due to the fact that said cell has not been used for a period of time, which can lead to capacity values (and also an internal resistance) that are slightly different from what it subsequently shows when it is used for a number of cycles.

Therefore, the relationship between SOC and FSOC is calculated, where appropriate, by analysing a detailed characterisation of several hundred cells. Specifically, for example, the initial resistance measured of the reception SOC of the cell ($R_{DC0}$) and the resistance measured with an SOC at 30% is adjusted, for example, using least squares adjustment after performing a series of cycles that eliminate the effect of inactivity ($R_{DC\_30}$).

Applying the previously obtained values of the simplified characterisation parameters ($V_{OC0}$,$R_{AC}$,$R_{DC-0}$,$R_{DC30}$), or values calculated from them (Voc, $R_{AC}$,$R_{DC0}$,$R_{DC\_30}$), in the predefined mathematical models, accurate estimates are obtained, on the one hand, of the capacity (C^) and, on the other hand, of the internal resistance ($R_{DC\_SOC}$), depending on the state of charge (SOC) of the batteries.

The present invention proposes three models 1-3, wherein, in model 1, both the capacity (C^) and the internal resistance ($R_{DC\_SOC}$) only depend on one of the simplified characterisation parameters, specifically the impedance ($R_{AC}$). In a more specific way, the capacity (C^) according to model 1 can be quadratic with respect to the impedance ($R_{AC}$), with an independent term ($C_{0\alpha}$) and a linear term ($\alpha_{1,c}$) and a quadratic term ($\alpha_{2,c}$), while the internal resistance ($R_{DC\_SOC}$) is linear with respect to the impedance ($R_{AC}$), with an independent term ($R_{DC0\alpha}$) and a linear term ($\alpha_{1,R}$). In turn, in model 2, both the capacity (C^) and the internal resistance ($R_{DC\_SOC}$) only depend on another one of the simplified characterisation parameters, specifically the resistance ($R_{DC\_30}$). In a more specific way, the capacity (C^) according to model 2 can be quadratic with respect to the resistance ($R_{DC\_30}$), with an independent term ($C_{0\beta}$) and a linear term ($\beta_{1,c}$) and a quadratic term ($\beta_{2,c}$), while the internal resistance ($R_{DC\_SOC}$) is linear with respect to the resistance ($R_{DC30}$), with an independent term ($R_{DC0\beta}$) and a linear term ($\beta_{1,r}$). Lastly, in model 3, both the capacity (C^) and the internal resistance ($R_{DC\_SOC}$) depend on the simplified characterisation parameters ($R_{AC}$,$R_{DC0}$). Specifically, both the capacity (C^) and the internal resistance ($R_{DC\_SOC}$) are quadratic in $R_{AC}$ and linear in $R_{DC\_30}$. The three models 1-3 obtained are shown below.

Model 1

$$C^\wedge = C_{0\alpha} + \alpha_{1,C} \cdot R_{AC} + \alpha_{2,C} \cdot (R_{AC})^2$$

$$R_{DC\_SOC} = R_{DC0\alpha} + \alpha_{1,R} \cdot R_{AC}$$

Model 2

$$C^\wedge = C_{0\beta} + \beta_{1,C} \cdot R_{DC\_30} + \beta_{2,C} \cdot (R_{DC\_30})^2$$

$$R_{DC\_SOC} = R_{DC0\beta} + \beta_{1,R} \cdot R_{DC\_30}$$

Model 3

$$C^\wedge = C_{0\gamma} + \gamma_{1,C} \cdot R_{AC} + \gamma_{2,C} \cdot (R_{AC})^2 + \gamma_{3,C} \cdot R_{DC\_30}$$

$$R_{DC\_SOC} = R_{DC0\gamma} + \gamma_{1,R} \cdot R_{AC} + \gamma_{2,R} \cdot (R_{AC})^2 + \gamma_{3,R} \cdot R_{DC\_30}$$

The model parameters ($C_{0\alpha}$; $\alpha_{1,C}$, $\alpha_{2,c}$; $R_{DC0\alpha}$; $\alpha_{1,R}$; $C_{0\beta}$; $\beta_{1,C}$; $\beta_{2,C}$; $R_{DC0\beta}$; $\beta_{1,R}$; $C_{0\gamma}$; $\gamma_{1,C}$; $\gamma_{2,C}$; $\gamma_{3,C}$; $R_{DC0\gamma}$; $\gamma_{1,R}$; $\gamma_{2,R}$; $\gamma_{3,R}$) are previously obtained through the detailed characterisation, as will be explained below.

The choice of the specific model to be followed depends on various determining factors. In general, model 3 is more accurate than any of the models 1 and 2, although it requires a greater investment (in time and/or equipment) when determining the model parameters, the simplified characterisation parameters and the detailed characterisation parameters. Specifically, selecting model 1 implies that it is only required to determine $R_{AC}$, just as using model 2 only requires determining $R_{DC\_30}$, while when using model 3 it is required to determine both $R_{AC}$ as $R_{DC\_30}$.

DETAILED CHARACTERISATION

The detailed characterisation is a step prior to the simplified characterisation, which allows the model parameters that characterise the initial battery pack to be obtained.

For detailed characterisation, equipment is used including: voltmeter; and equipment for cell cycling, with the capacity to measure and store voltage and current data.

The steps of an exemplary detailed characterisation are described below:

1- Measuring open-circuit voltage ($V_{OC}$) in the battery at the SOC at which it is received. This step does not have an influence on determining the detailed characterisation parameters ($R_{AC}$, $R_{DC\_i}$), although it is optionally included in the detailed characterisation to rule out batteries the open-circuit voltage of which is not within a range pre-established by the manufacturer, for example for safety reasons.

2- Measuring impedance ($R_{AC}$) of the battery at a predetermined frequency, such as 1 kHz, by means of the impedance meter.

3- Measuring discharge capacity (C) of the battery, for example, in a discharge operation, based on the time and intensity of said discharge operation. According to a preferred exemplary embodiment, the discharge capacity (C) is measured according to the following standard sequence.

- CC-CV charge (constant current and constant voltage) with predetermined current, for example, C/3 (according to the standard) in the CC phase up to a predetermined voltage level, for example, the maximum voltage level established by the manufacturer, with a cut-off current of the predetermined CV phase, which is according to the standard, C/30.
- CC discharge at predetermined current, for example C/3, up to a predetermined voltage level, for example the minimum voltage level established by the manufacturer.
- Repetition of the CC-CV charge and CC discharge steps a predefined number of times, for example three times. At the end of the last repetition, measuring (C).

4- Calculating discharge resistance ($R_{DC\_i}$) at different levels of state of charge (SOC), indicated by the subscript *i* included between [0, 100] %. In other words, $R_{DC\_i}$ is actually a vector. To do this, the battery is subjected to a series of consecutive progressive discharges, between predetermined SOC values. The voltage (V2) and the current (I2) are measured after each discharge and also before each discharge (V1, I1), so that the value of $R_{DC\_i}$ is calculated as $R_{DC\_i}$ = (V2-V1) / (I2-I1), wherein *i* refers to the state of charge at which the discharge begins. According to a preferred exemplary embodiment, the discharge resistance ($R_{DC\_i}$) is measured according to the following standardised sequence, wherein $R_{DC\_i}$ is a five-component vector, since *i* has five values that refer to states of charge (SOC) of 90%, 70%, 50%, 30%, and 10%:

- CC-CV full charge with the predetermined current (such as C/2, according to regulations) in the CC phase up to a predetermined voltage level (such as the maximum voltage level established by the manufacturer) and with a cut-off current of the predetermined CV phase, such as C/30.
- DC discharge of the cell of 10%, from 100% to 90%, with the predetermined current, for example, of C/2.
- Rest, for example for 1 hour, to reach thermodynamic equilibrium.
- DC discharge of the cell by 20%, from 90% to 70%, with predetermined current, for example, of C/2.
- Repeating the two previous steps a total of 4 times, going from 70% to 50% and from 50% to 30%, at a predetermined current, such as for example C/2.
- DC discharge of the cell by 5%, from 10% to 5% at predetermined current, such as for example C/2.

- Calculating $R_{DC\_i} = (V2-V1) / (I2-I1)$ in each of the five discharge repetitions in the steps after the first one, with V2 and I2 being the voltage and current measured after each discharge and V1 and I1 being the voltage and current measured before each discharge. The component "i" of the subscript in $R_{DC\_i}$ refers to each of the five measurements. In particular, "i" refers to the state of charge from which each of the discharges is carried out, which in the example being explained, has the values of (90, 70, 50, 30, 10).

5.- Estimating a relationship between SOC and Voc using a predetermined function type. In a preferred exemplary embodiment of the present invention, the predetermined function is a polynomial, such as a polynomial of order 5 (P5), wherein SOC = P5($V_{OC}$). According to an exemplary embodiment, the values of $V_{OC}$ and SOC are taken for each battery during a discharge process and during a subsequent charge process, both at very low current, and the predetermined function is adjusted based on the voltage mean during charge and discharge. A standard example is explained below:

- CC-CV full charge with the predetermined current, such as C/2, in the CC phase up to a predetermined voltage level, such as the maximum voltage level established by the manufacturer, and with a cut-off current of the predetermined CV phase, such as C/30.
- DC discharge at predetermined current, such as C/30, up to the predetermined voltage level, such as the minimum level established by the manufacturer. Measuring the voltage during the discharge process (this voltage is equivalent to the open-circuit $V_{OC}$).

- Optional: CC charging at predetermined current, for example C/30, up to the predetermined voltage level, for example the maximum level established by the manufacturer. Measuring the voltage during the charging process (this voltage is equivalent to the open-circuit $V_{OC}$, and can be averaged with the corresponding discharge measurement to obtain an averaged open-circuit voltage).

With the previously determined detailed characterisation parameters ($V_{OC}$, $R_{AC}$, C, $R_{DC\_i}$), the following mathematical adjustments are made to obtain the model parameters, wherein adjustments 1 and 2 refer to model 1; adjustments 3 and 4 refer to model 2, and adjustments 5 and 6 refer to model 3.

1- In the expression of C^ of model 1, the values of C obtained are substituted as C^, and the values of $R_{AC}$ as $R_{AC}$ and it is adjusted, for example using least squares adjustment, obtaining the parameters $C_{0\alpha}$, $\alpha_{1C}$ and $\alpha_{2C}$.

2- In the expression of $R_{DC\_SOC}$ of model 1, wherein the "SOC" portion of the subscript refers to the state of charge, the values of $R_{DC\_i}$ obtained are substituted as $R_{DC\_SOC}$, and those of $R_{AC}$ as $R_{AC}$ and it is adjusted, for example using least squares adjustment, obtaining five values (i=10, 30, 50, 70, 90) for the parameters $R_{DC0\alpha}$, $\alpha_{1R}$.

3 - In the expression of C^ of model 2, the values of C obtained are substituted as C^, and those of $R_{DC\_30}$ as $R_{DC\_30}$ ($R_{DC\_i}$ for state of charge SOC = 30 %) and it is adjusted, for example using least squares adjustment, obtaining the parameters $C_{0\beta}$, $\beta_{1C}$ and $\beta_{2C}$.

4 - In the expression of $R_{DC\_SOC}$ of model 2, the values of $R_{DC\_i}$ obtained are substituted as $R_{DC\_SOC}$, and $R_{DC\_30}$ as those of $R_{DC\_30}$ ($R_{DC\_i}$ for state of charge SOC = 30 %), and it is adjusted, for example using least squares adjustment, obtaining five values (i=10, 30, 50, 70, 90) for the parameters $R_{DC0\beta}$, $\beta_{1R}$.

5- In the expression of C^ of model 3, the values of C obtained are substituted as C^, as well as $R_{AC}$ is substituted as $R_{AC}$ and $R_{DC\_30}$ as $R_{DC\_30}$ ($R_{DC\_i}$ for the state of charge SOC = 30 %) and it is adjusted, for example using least squares adjustment, obtaining the parameters $C_{0\gamma}$, $\gamma_{1C}$, $\gamma_{2C}$ and $\gamma_{3C}$.

6- In the expression of $R_{DC\_SOC}$ of model 3, the values of $R_{DC\_i}$ obtained are substituted as $R_{DC\_SOC}$, and the values of $R_{AC}$ are substituted as $R_{AC}$ and the values of $R_{DC\_30}$ are substituted as $R_{DC\_30}$ ($R_{DC\_i}$ for state of charge SOC = 30 %), and it is adjusted, for example using least squares adjustment, obtaining five values (i=10, 30, 50, 70, 90) for the parameters, obtaining five values (i=10, 30, 50, 70, 90) for parameters $R_{DC0\gamma}$, $\gamma_{1R}$, $\gamma_{2R}$ and $\gamma_{3R}$.

STATISTIC ANALYSIS

As previously mentioned, substituting the simplified characterisation parameters in the expressions of the models serves to more accurately estimate the capacity and internal resistance of new batteries, but only when the new batteries are sufficiently similar to the previous batteries so that the model parameters of the previous batteries are applicable to the current batteries.

For this reason, the present invention contemplates a statistical analysis which, after the simplified characterisation of the current batteries, makes it possible to statistically determine if the model parameters of any of the previous battery packs are applicable thereto.

The steps of an exemplary statistical analysis are provided below.

1- Normality test, for example, Shapiro-Wilk test of the $R_{AC}$ data measured in the simplified characterisation, to determine if they follow a normal distribution.

2- If the p-value of the step 1 test is greater than 0.05, that is, if the $R_{AC}$ of the simplified characterisation follow a normal distribution, an ANOVA analysis is performed to compare the sample medians between the $R_{AC}$ data measured in the detailed characterisation and the $R_{AC}$ values measured in the simplified characterisation.

3- If, on the other hand, the p-value of the step 1 test is less than 0.05, that is, if the $R_{AC}$ of the simplified characterisation do not follow a normal distribution, a Kruskal-Wallis analysis is performed to compare the sample medians between the $R_{AC}$ data measured in the detailed characterisation and $R_{AC}$ values measured in the simplified characterisation.

4- If the p-value of the ANOVA test of step 2, or of the Kruskal-Wallis test of step 3, as appropriate, is greater than 0.05, the estimation results of the capacity ($C^{\wedge}$) and the internal resistance ($R_{DC\_SOC}$) by means of model 1 are considered valid.

5- If, on the contrary, the p-value of the ANOVA test of step 2, or of the Kruskal-Wallis test of step 3, as appropriate, is less than 0.05, the model 1 of none of the previous battery packs characterised in detail is applicable to the current battery pack, whereby the batteries being characterised could be subjected to a detailed characterisation.

6- Repeating steps 1 to 3 with respect to, on the one hand, the values of $R_{DC0}$ measured in the simplified characterisation for model 2 and, on the other hand, with respect to $R_{DC\_30}$ measured in the detailed characterisation, for model 3.

7- If the p-value of the test in step 2 or step 3, as appropriate, is greater than 0.05, the estimation results of the capacity ($C^{\wedge}$) and the internal resistance ($R_{DC\_SOC}$) ) are considered valid by means of models 2 and 3, as appropriate.

8- If the p-value of the test in step 2 or in step 3, as appropriate, is less than 0.05, models 1 and 3 of none of the previous battery packs characterised in detail is applicable to the current battery pack, whereby it would be appropriate to perform a detailed characterisation for the current cell pack.

## Brief description of the figures

The foregoing and other advantages and features will be better understood based on the following detailed description of several embodiments in reference to the attached drawings, which must be interpreted in an illustrative and non-limiting manner and in which:

- Figure 1 shows a general flowchart of the method of the invention.
- Figure 2 shows a flowchart of the statistical analysis step of the invention.
- Figure 3 shows a flowchart of the simplified characterisation step of the invention.
- Figure 4 shows a flowchart of the detailed characterisation step of the invention.

## Detailed description of a preferred embodiment of the invention

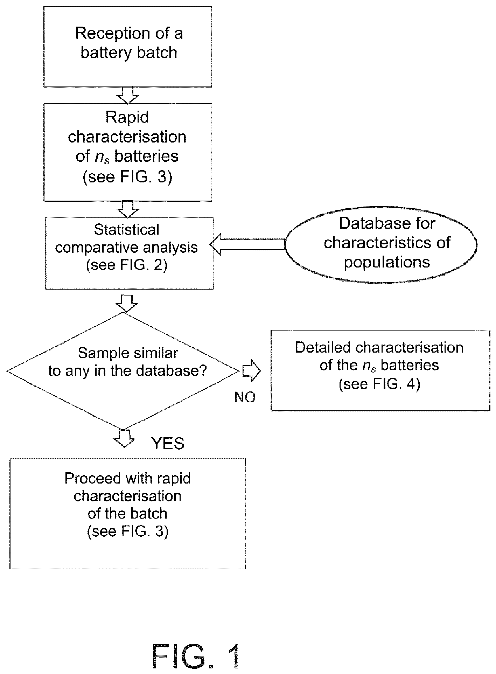

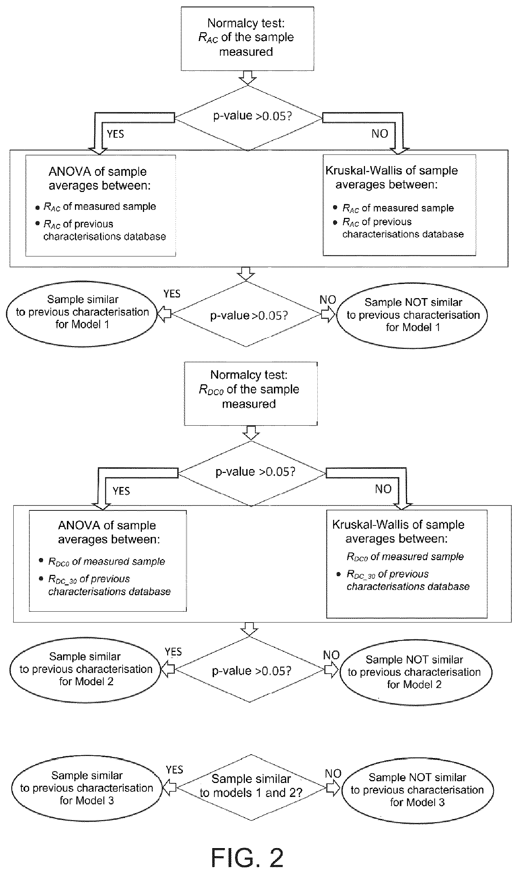

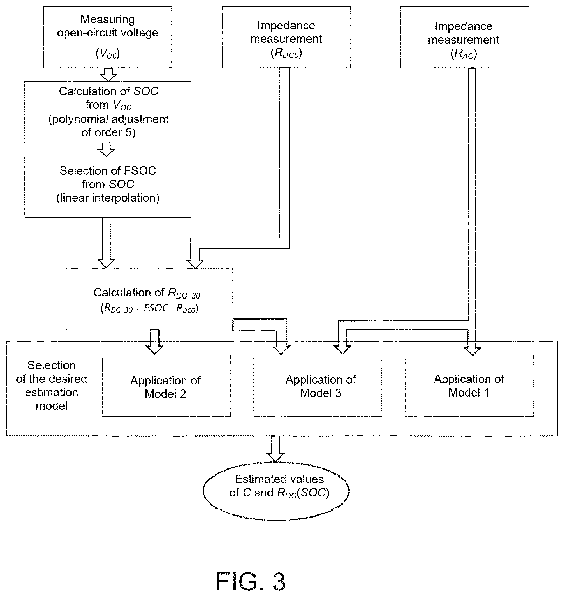

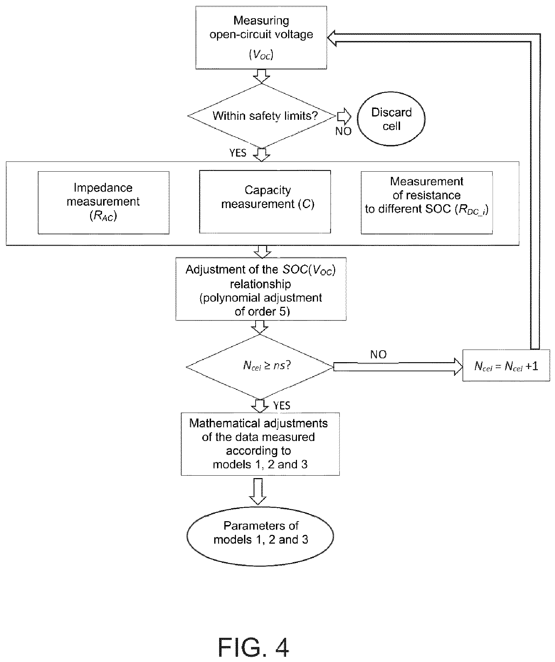

A detailed description of a preferred embodiment of the method for characterising batteries according to the present invention is provided below, with the aid of the aforementioned figures 1-4.

This method provides a methodology that allows the capacity and internal resistance of second-life batteries to be estimated through rapid and simple tests that are applicable to cells, modules and battery packs, and is also easily able to be extrapolated for the characterisation of other types of batteries other than lithium-ion batteries. Extensive samples of batteries intended for a second life have been provided for the creation and experimental validation of the method, as described below. Firstly, the proposed methodology to create the estimation method is described; and secondly, the experimental method, the batteries analysed and the test bench are described. The proposed estimation method is then validated and applied to batteries intended for a second life, removed from Nissan Leaf electric vehicles. Lastly, the main conclusions with respect to the method are collected.

## 1- GENERAL METHODOLOGY

The parameters of the battery that will be estimated to know the state of health (SOH) of the battery are the capacity ($C^{\wedge}$) and the internal resistance ($R_{DC\_SOC}$) based on the state of charge (SOC) thereof.

In a first phase, one or several populations i are characterised, wherein firstly the study level of the populations is defined, meaning, if cells, modules or battery packs are analysed, and a sample size $n_s$ is selected from each of the populations, on which a detailed characterisation is performed allowing the receptor status thereof to be known. After a screening to eliminate the samples that are not suitable for reuse, the models are adjusted.

In a second phase, a new sample 1 (M1) made up of n1 cells or modules is received. First, a simplified characterisation of M1 is performed, and it is statistically determined whether it belongs to any of the previously characterised populations i. If it does, C^ and $R_{DC\_SOC}$ will be estimated with the estimation models created and adjusted to said population. In the case that it does not belong to an already characterised population, it is possible to characterise the population M1 in a detailed way, to incorporate it into the pack of populations i, for which a subsample of size $n_s$ (M1.1) is performed and the previously explained first phase is applied to the same, to characterise the new M1 population.

With respect to the selection of the study level, the reuse of batteries for a second life thereof is not a standardised process, and therefore reusing is possible at cell-, module- or battery-pack level. Thus, in the case that more than one accessible unit is available, for example modules and the corresponding cells thereof, it is convenient to assess which is the most appropriate study level.

On the one hand, the characterisation at module level entails shorter test times. However, it requires higher voltage ranges in the pieces of equipment, which could increase the final cost of the process. This option provides a general idea of the internal condition of the cells that make up the module, and can be advantageous in the case that reuse of the cell is not profitable and, therefore, the internal dispersion of the module must be assumed due to differences among the cells that make it up. Compared to this option, analysis of the cells leads to greater accuracy, which can be advantageous for balancing in second-life applications.

On the other hand, the characterization at cell level would provide details on the internal dispersion of the modules. Furthermore, this option is advantageous in terms of equipment costs, since narrower voltage ranges are required. The choice between cell or module (or even battery pack) level, if possible, will therefore depend on the interests in each specific case.

1.1.- Detailed characterisation

Detailed characterisation is performed on $n_s$ elements of a sample M0.

- First, the open-circuit voltage ($V_{OC0}$) is measured, discarding those batteries with voltages outside the safety range indicated by the manufacturer.

- To measure the discharge capacity (C), the battery is left at rest for 2 hours at the test temperature, so that it reaches thermodynamic equilibrium. Next, a sequence of three CC-CV charge + CC discharge cycles is carried out between the maximum and minimum voltage limits. The CC phases are done at C/3, and the cut-off current in the CV step is C/30. The discharge capacity (C) is determined based on the discharge measurement of the third cycle, for example based on the discharge current and the discharge time.

- The test for measuring internal resistance ($R_{DC\_SOC}$) starts with a full CC-CV charge at C/2; the battery is then discharged at C/2 up to SOC = 90%. At this point, a rest period of 1 hour is established, so that thermodynamic equilibrium is reached, at the end of which, the voltage (V1) is measured, and a CC to C/2 discharge pulse is carried out until reaching the next SOC level. 10 seconds after the discharge pulse, the voltage and current measurement (V2 and I2) is taken. The internal resistance is calculated as $R_{DC\_SOC} = (V2 - V1) / I2$. This method is repeated for 5 SOC levels: 90%, 70%, 50%, 30% and 10%. Both tests are performed at room temperature of the laboratory (23 $\pm$ 2 °C).

To determine the relationship between $V_{OC}$ and SOC, a quasi $V_{OC}$ test is performed, in other words, a discharge and a charge with a current so low (for example, C/30) that the deviation between the voltage measured in the cell and the open-circuit voltage ($V_{OC}$) can be disregarded. In the quasi $V_{OC}$ test, the charge and discharge voltage for each cell are measured, as well as the median value thereof. Starting with a fully charged cell, it is left at rest for 2 hours and a discharge is performed at C/30 with a CC order up to the lower voltage limit. Then, after a rest period of 2 hours, a CC charge is performed at the same current.

The SOC-$V_{OC}$ curve is found taking the median of the charge and discharge voltage measurements. Based on the results of this characterisation, if there is a criterion for discarding cells due to excessive degradation, these elements are eliminated and replaced by other elements to maintain the sample size $n_s$.

1.2.- Simplified characterisation

The simplified characterisation is performed when there is a new sample M1, with size n1, of a new population 1 to be rapidly characterised, based on the detailed characterisation previously carried out on the sample M0.

The rapid characterisation methodology consists of:

- Measuring the open-circuit voltage ($V_{OC}$).
- Measuring impedance at 1 kHz ($R_{AC}$).
- Performing a discharge step current at C/2 for a duration of 10 seconds, after which the voltage and current measurement (V2 and I2) is taken. $R_{DC0}$ = (V2 - V1) / I2 is calculated.

After doing these rapid characterisation tests, an analysis must be made with regard to whether Sample 1 belongs to any of the already characterised populations or if, on the contrary, it is a new population that requires a new detailed characterisation.

First of all, an analysis must be made as to whether the models created from the characterisation of Population 0 are directly applicable to Population 1 or if an adjustment of same is required. This would be valid if both populations are similar. If not, they should be adjusted. To do this, there are different statistical methods, such as the analysis of variance (ANOVA) or the Kruskal-Wallis test. Both methods start from the null hypothesis of equality between groups, which are rejected with 95% confidence if the resulting p-value indicator is less than 0.05. Since the ANOVA test compares the medians, it is mainly used in normal distributions. Furthermore, the Kruskal-Wallis test is based on medians, which is why it is recommended for samples with outliers. For this, a normalcy test (for example, the Shapiro-Wilk test) is first performed on the data from the rapid characterisation test, in order to determine whether to use the ANOVA test or the Kruskal-Wallis test.

To design the models, a detailed search analysis of the most significant variables is carried out to estimate C and $R_{DC\_SOC}$. It should be noted that the aim is to find the variables that have the greatest correlation with C and $R_{DC\_SOC}$. To numerically determine the degree of correlation between variables, the Pearson linear correlation coefficient is used as an indicator. Given a sample of n random pairs of two variables (X, Y) it is possible to calculate the Pearson linear correlation coefficient (*rX,Y*), according to the Equation (1).

$$r_{X,Y} = \frac{COV(X,Y)}{\sigma_X \sigma_Y} \quad (1)$$

Wherein *COV(X, Y)* is the covariance, $\sigma X$ the standard deviation of *X,* and $\sigma Y$ is the standard deviation of *Y.* The value of $r_{X,Y}$ ranges from -1 to +1, wherein +1 implies perfect positive correlation, 0 the absence of linear correlation, and -1 perfect negative correlation. The degree of correlation can be further classified according to the following intervals:

| | |
|---|---|
| *|rX,Y|*<0.3 | No correlation |
| 0.3≤*|rX,Y|*<0.5 | Weak correlation |
| 0.5≤|rX,Y|<0.8 | Moderate correlation |
| 0.8≤|rX,Y| | Strong correlation |

In order to identify the variables that have the highest correlation with C^ and $R_{DC\_SOC}$, the measurements performed in the detailed characterisation test are adjusted using simple linear regression with the detailed characterisation parameters ($R_{AC}$, $R_{DC0}$ and $V_{OC}$), and in each case the Pearson correlation coefficient and the p-value obtained in the ANOVA test are found, which are shown in Table 1 below. As can be seen, the Pearson coefficient indicates a strong correlation of capacity and internal resistance with $R_{AC}$, $R_{DC\_30}$ or $R_{DC0}$, while for $V_{OC}$ it is quantified as weak. In addition, the ANOVA test also rejects the null hypothesis of the absence of correlation of the variables $R_{AC}$, $R_{DC\_30}$ or $R_{DC0}$, but not for $V_{OC}$. Thus, it is concluded that the significant variables for estimating capacity are $R_{AC}$ and $R_{DC}$.

**Table 1: Results** of the correlation analysis between measured variables and capacity and internal resistance.

| PARAMETER | COUNT | | C^ | | | $R_{DC\_50}$ |
|---|---|---|---|---|---|---|
| | | r | ANOVA p-value | r | ANOVA p-value | |
| $R_{AC}$ | 100 | -0.927 | 0.000 | 0.900 | 0.000 | |
| $R_{DC\_30}$ / $R_{DC0}$ | 100 | -0.945/ - | 0.000 / - | 0.997 / 0.986 | 0.000 / 0.000 | |
| $V_{OC}$ | 100 | 0.070 | 0.487 | -0.062 | 0.542 | |

To determine the measurement of $R_{DC}$, it must be taken into account that, whereas $R_{AC}$ is independent of the SOC, the value of $R_{DC}$ changes with the SOC. Therefore, it is proposed to correct the $R_{DC}$ measured in the rapid characterisation process by means of a step current ($R_{DC0}$) at the resistance value at a 30% charge. In addition, this factor is used to correct the activation effect that occurs in the batteries, once the first cycles have been performed after prolonged storage. The value of this correction factor, (Fsoc) is calculated by its median value, as shown in Equation (2), wherein the lines indicate median values. The values obtained for this correction factor are shown in Table 2.

$$F_{SOC} = \overline{RDC-30}/\overline{RDC-SOC0} \tag{2}$$

Table 2: factors to adapt $R_{DC0}$ to $R_{DC\_30}$ for use in capacity estimation models. Data corresponding to population 0.

| SOC (%) | 10 | 20 | 30 | 40 | 50 |
|---|---|---|---|---|---|
| $F_{SOC}$ | 0.9093 | 0.9670 | 0.9693 | 1.0103 | 0.9865 |

Therefore, two significant variables have been identified for the estimation of C and $R_{DC\_SOC}$, which are $R_{AC}$ and $R_{DC\_30}$. In order to parameterise this correlation, Equation 3 will be taken as a general expression, which describes an estimated dependent variable $Y^{\wedge}$ as a function of different known variables $X$ for a model i. The data analysed correspond to the measurements of the detailed characterisation test.

$$\widehat{Y_i} = Y_o + \alpha_1 X_1 + \beta_1 X_2 + \gamma_1 X_3 + \cdots + \alpha_1 X_1^m + \beta_m X_2^m + \gamma_n X_3^m$$

$$(3)$$

Thus, in case there is more than one variable, as many models as variables will be distinguished, plus one that combines all of them. In this way $Y^{\wedge}1=f(X1)$, $Y^{\wedge}2=f(X2)$, ..., $Y^{\wedge}n+1=f(X1, X2,...,Xn)$. In each model, the aim is to determine the degree and the coefficients that best describe the correlation with variable Y. In each case, to determine the optimal degree, a value (m) will be selected and the hypothesis of significance of the variable for the estimation will be tested with an ANOVA test. In the event that the p-value is less than 0.05, this hypothesis will be accepted and said value m will be taken. Otherwise, the process will be repeated with m being equal to the immediately lower integer, until finding the degree that takes into account all the significant terms. Next, the resulting polynomial will be adjusted using least squares adjustment.

Therefore, the three previously explained estimation models are parameterised, based on the results of the characterisation tests, wherein the values of the $\alpha$ and $\beta$ parameters are calculated for each new population. Thus, three models are distinguished, one for each of the two aforementioned significant variables $R_{AC}$ and $R_{DC\_30}$, plus another one with multiple regression of both. C has a second order relationship for both $R_{AC}$ and $R_{DC\_30}$, while $\bar{R}_{DC\_SOC}$ has a linear correlation with both $R_{AC}$ and $R_{DC\_30}$. In the case of Model 3, the optimal correlation is a second order for $R_{AC}$ and a first order for $R_{DC\_30}$.

2.- TEST BENCH

The methodology proposed in section 1 is experimentally supported in 203 modules and 3 battery packs removed from actual electric vehicles. Below, the batteries used are first described, and then the laboratory equipment is described.

2.1.- Description of the batteries.

The batteries analysed come from different Nissan Leaf electric vehicles. The background of the first life of said batteries is unknown. Each Nissan Leaf battery pack is made up of a total of 48 modules in a serial configuration. In turn, the modules are made up of four pouch cells made of graphite and manganese oxide (LMO/C), connected by pairs associated in series, in other words, in a 2s2p configuration. Each module has three external terminals: positive (R), midpoint (W), and negative (N). Thus, the cells cannot be tested individually, but in 2p pairs. Since this 2p is the smallest unit available, from now on it will be referred to as "cell", in order to make it easier to read. Thus, Cell-SUP refers to the pair of cells between terminals R and W and Cell-INF corresponds to the 2p cells between W and B. The main battery pack, module and cell specifications are shown in Table 3.

EP 4 382 929 B1

Table 3: Battery pack, module and cell specifications for the Nissan Leaf electric vehicle.

|  | BATTERY PACK | MODULE | CELL (2p) |
|---|---|---|---|
| Nominal voltage (V) | 360 | 7.50 | 3.75 |
| Maximum voltage (V) | 403.2 | 8.30 | 4.15 |
| Minimum voltage (V) | 240 | 2.0 | 2.5 |
| Rated capacity (Ah) | 66.2 | 66 | 66 |
| Rated Energy (Wh) | 24000 | 495.0 | 247.5 |
| Rated DC internal Resistance SOC = 0.5 (m$\Omega$) | 93.1 | 1.94 | 0,970 |
| Rated AC resistance (m$\Omega$) | 59.8 | 1.25 | 0.623 |
| Length x width x thickness (mm) | 1570.5 x 1188.0 x 264.9 | 303 x 223 x 35 | - |
| Mass (kg) | 1505 | 3.85 | 1.57 |

2.2.- Laboratory equipment

Three 16-channel cyclers (5 V and 50 A each) have been used, having an accuracy of $\pm$0.1% of full scale. In addition, two thermal cameras have been used (temperature range -30 °C to +180 °C), which have an accuracy of $\pm$0.5 °C. Moreover, there is a voltage source (400 V and 90 A), with an accuracy of $\pm$0.1% of full scale (FS: 800 V and 90 A). The impedance measurement has been carried out with a battery analyser with a resolution of 0.001 m$\Omega$ and an accuracy of $\pm$1% of full scale. The maximum voltage of this analyser is 60 V and the amplitude of the injected source signal is less than 100 mA. The open-circuit voltage of the cells is measured with a 0.1 mV resolution multimeter. For data processing and statistical analysis, the software Matlab and StatGraphics are used.

3.- EXPERIMENTAL APPLICATION OF THE METHOD AND DISCUSSION

This section shows the experimental results that support the rapid estimation methodology proposed above. As mentioned, the target variables for the estimation are capacity (C^) and internal resistance ($R_{DC\_SOC}$) based on state of charge (SOC). For validation, there are 203 modules removed from electric vehicles (EV) and 3 battery packs intended for a second life.

3.1.- Detailed characterisation of Sample 0

Cell-level characterisation is selected as the study level. As a starting point, the complete characterisation of the first population (Population 0) will be carried out, which includes the 203 pairs of Cell-SUP cells.

First, the $V_{OC}$ of the cells is measured, and since no value was detected outside the ranges established in Table 3, the characterisation method is followed, sequentially measuring $R_{AC}$ and $R_{DC0}$. In addition, since a complete characterisation of this population is required, the measurement of C and $R_{DC\_SOC}$ is performed, as described above, to a Sample 0 of $n_s$=100 cells. Since the $V_{OC}$-SOC relationship presents a very low variability in lithium batteries, the quasi-$V_{OC}$ test is performed only in one of the cells. Table 4 shows the statistical summary of the characterisation measures of Sample 0, determining the mean, standard deviation (Std), the maximum (Max) and minimum (Min) value, and the coefficient of variation (CV = Std / Mean). The measurement of $V_{OC}$ is replaced by its equivalent SOC, found from the $V_{OC}$-SOC curve. The rest of the values are normalised with respect to the reference values for the cells studied, indicated in Table 3. As limit values to allow the reuse of batteries, 0.55 are taken for C and 4 for $R_{DC\_SOC}$ and $R_{AC}$, based on experimental degradation tests carried out with similar modules. None of the measured data is outside these limits, so the cells are considered valid for analysis.

Table 4: Characterisation results of Sample 0.

|  | $R_{AC}$ | SOC-0 | $R_{DC0}$ | C | $R_{DC\_90}$ | $R_{DC\_70}$ | $R_{DC\_50}$ | $R_{DC\_30}$ | $R_{DC\_10}$ |
|---|---|---|---|---|---|---|---|---|---|
| Mean | 2.02 | 36.2 | 2.20 | 0.66 | 2.13 | 2.08 | 2.14 | 2.13 | 2.37 |
| Std | 0.26 | 5.6 | 0.28 | 0.07 | 0.27 | 0.26 | 0.28 | 0.27 | 0.30 |
| Max | 2.42 | 74.3 | 2.61 | 0.95 | 2.56 | 2.46 | 2.54 | 2.54 | 2.87 |
| Min | 0.99 | 11.2 | 1.13 | 0.57 | 1.08 | 1.07 | 1.06 | 1.10 | 1.26 |

(continued)

|  | $R_{AC}$ | SOC-0 | $R_{DC0}$ | C | $R_{DC\_90}$ | $R_{DC\_70}$ | $R_{DC\_50}$ | $R_{DC\_30}$ | $R_{DC\_10}$ |
|---|---|---|---|---|---|---|---|---|---|
| CV(%) | 13.06 | 15.5 | 12.77 | 11.18 | 12.97 | 12.63 | 13.16 | 12.84 | 12.68 |

As Table 4 shows, the normalised C values range from 0.57 to 0.95. The median value is 0.66, data lower than the SOH of theoretical withdrawal of the regulations for lithium ion batteries in electric vehicles. As for $R_{DC}$, it is observed that the mean, maximum and minimum values of the initial step ($R_{DC0}$) are higher than those of the closest fixed SOC test ($R_{DC\_30}$) for similar coefficients of variation. This may be because the measure of $R_{DC0}$ is carried out after a long-term rest of the cell, of weeks or even months, while the $R_{DC\_SOC}$ test is carried out after several cycles, which favours the internal kinetics of the cells and therefore decreases the internal resistance.

3.1.1.- Characterisation of population 0

The experimental results described are adjusted, using linear regression techniques, to the three models described above. Table 5 shows the best fit and the coefficients for each case, as well as the accuracy, determined from the adjusted coefficient of determination (Rsq,adj). Note that $R_{DC\_30}$ is only estimated from Model 1.

Given that both the detailed characterisation tests and the results of the simplified characterisation are available in this sample, it is possible to compare the accuracy of the models based on the estimation error for C defined from Equation (4) below.

$$\delta = \frac{|Y-\hat{Y}|}{Y} \quad (4)$$

If the estimation error ($\delta i$) for C^ is determined for the three proposed models, it is obtained that Model 3 has the best estimation results, with a median error of 1.6%, compared to 1.8% of Model 2 and 2.6% of Model 1. Models 2 and 3 show the best results, which can be justified by the higher correlation and consequent quality of the adjustment of $R_{DC}$ with the capacity with respect to the $R_{AC}$ data.

Table 5: Coefficients and coefficient of determination for the best adjustment of capacity and $R_{DC}$ estimated from $R_{AC}$ (Model 1), $R_{DC\_30}$ (Model 2) and both (Model 3) in Sample 0.

| Model | Xi | Y | Yo | $\alpha1$ | $\alpha2$ | $\beta1$ | $\beta2$ | Rsq,adj |
|---|---|---|---|---|---|---|---|---|
| 1 | $R_{AC}$ | C | 1.4602 | -0.6149 | 0.1058 | - | - | 0.8881 |
|  |  | $R_{DC\_90}$ | 0.2407 | 0.9352 | - | - |  | 0,795 |
|  |  | $R_{DC\_70}$ | 0.2816 | 0.8903 | - | - |  | 0.7946 |
|  |  | $R_{DC\_50}$ | 0.1985 | 0.9626 | - | - |  | 0.8075 |
|  |  | $R_{DC\_30}$ | 0.2549 | 0.9267 | - | - |  | 0.7994 |
|  |  | $R_{DC\_10}$ | 0.3374 | 1.0052 | - | - |  | 0.7767 |
| 2 | $R_{DC\_30}$ | C | 1.5887 | - | - | -0.6952 | 0.1187 | 0.9373 |
|  |  | $R_{DC\_90}$ | -0.0189 | - | - | 1.0102 |  | 0.9961 |
|  |  | $R_{DC\_70}$ | 0.0372 | - | - | 0.9605 |  | 0.9959 |
|  |  | $R_{DC\_50}$ | -0.0500 | - | - | 1.0311 |  | 0.9951 |
|  |  | $R_{DC\_30}$ | - | - | - | - |  | - |
|  |  | $R_{DC\_10}$ | 0.0456 | - | - | 1.0919 |  | 0.9847 |
|  | $R_{AC}$ | C | 1.4311 | -0.4016 | -0.1412 | 0.0814 |  | 0.9418 |
|  |  | $R_{DC\_90}$ | -0.0131 | -0.0117 | 0.0018 | 1.0150 |  | 0.9962 |

(continued)

| Model | Xi | Y | Yo | $\alpha 1$ | $\alpha 2$ | $\beta 1$ | $\beta 2$ | Rsq,adj |
|---|---|---|---|---|---|---|---|---|
| 3 | $R_{DC\_30}$ | $R_{DC\_70}$ | -0.0526 | 0.1218 | -0.0342 | 0.9538 | | 0.9612 |
| | | $R_{DC\_50}$ | -0.2291 | 0.2682 | -0.0659 | 0.9891 | | 0.9961 |
| | | $R_{DC\_30}$ | - | - | - | - | | - |
| | | $R_{DC\_10}$ | 0.4991 | -0.6366 | 0.1707 | 1.1501 | | 0.9893 |

Moreover, regarding the estimation errors for $R_{DC}$ for each SOC value, large differences were detected between the accuracy of Model 1, with median error values between 3.7 and 4.1%, and the results obtained with Models 2 and 3, the medians of which range between 1.2% and 1.9% and 0.9% and 1.5% respectively. This is due to the higher degree of correlation observed with $R_{DC}$. Accounting for outliers, Model 3 provides the best results, with whisker lengths between 3.4% and 1.9% of the error. Comparing between estimates of $R_{DC}$ at different SOC, it is observed that the worst estimation results are at 10% SOC, a fact attributable to the greater values measured (see Table 4), which condition the quality of the adjustments (see Table 5).

3.2.- Rapid estimation of capacity

In this second phase, a rapid estimation of capacity is performed in different samples. In order to compare various scenarios, two samples of the same chemistry and technology as Population 0 are considered.

- Sample 1: Cell-SUP cells from a batch other than the previous ones. n1 = 103 units.
- **Sample 2:** Cell-INF cells. n2 = 203 units.

First, a rapid characterisation of both samples is performed. Table 6 shows the statistical summary of the results, with $R_{AC}$ and $R_{DC0}$ normalised with respect to the nominal values of Table 3. The results show higher median resistance values in Sample 2. Given that the differentiating feature between the samples is the position of the cells within the module, this fact confirms that the firstlife background leads to uneven aging among them, with a slightly higher condition in those located in the lower position (Cell-INF). The great variability of SOC observed in Sample 2 should be noted, being three times higher than Sample 1, which, together with the extreme values of SOC (98%) observed, confirm the convenience of adapting the value of $R_{DC0}$ to a fixed SOC value to avoid this variability.

Table 6: Rapid characterisation results in Populations 1 and 2.

| | $R_{AC}$ | | $SOC_0$ (%) | | $R_{DC0}$ | |
|---|---|---|---|---|---|---|
| | Sample 1 | Sample 2 | Sample 1 | Sample 2 | Sample 1 | Sample 2 |
| Mean | 1.99 | 2.11 | 36.1 | 39.2 | 2.17 | 2.38 |
| Std | 0.40 | 0.32 | 3.8 | 13.3 | 0.38 | 0.39 |
| Max | 2.70 | 2.71 | 50.4 | 98.1 | 2.69 | 2.96 |
| Min | 0.98 | 1.16 | 11.1 | 10.9 | 1.20 | 1.19 |
| CV (%) | 20.01 | 15.24 | 10.6 | 34.0 | 17.34 | 16.90 |

In a second step, these samples are evaluated to check if they belong to Population 0. To do this, as previously explained, a normalcy test is performed on the rapid characterisation data and the ANOVA method or the Kruskal-Wallis method is applied as appropriate. These normalcy tests indicate that none of the experimentally measured variables follows a normal distribution. Thus, the Kruskal-Wallis method is applied, obtaining p-values of 0.32 and 0.13 for $R_{DC0}$ and $R_{AC}$ in Sample 1, which leads to the conclusion that Sample 1 belongs to Population 0. However, in the case of Sample 2, p-values of 0.00 are obtained for both variables, which indicates that Sample 2 does not belong to Population 0.

Therefore, we can use the data from Population 0 to estimate the characteristics of Sample 1. Thus, applying the coefficients of Table 5 to the results of the rapid characterisation, the estimation of the capacity (C^) and the internal resistance ($R_{DC\_SOC}$) is obtained.

Moreover, Sample 2 consists of cells with different characteristics from Population 0, so that it is required to adjust the estimation models to adapt them to the new data, characterising the socalled Population 1. Continuing with the proposed methodology, a sample of size $n_s = 40$ is taken from said population. The rest of the tests are carried out on said sample for the detailed characterisation thereof, in accordance with the previously explained methods. In this way, we obtain, in addition to $V_{OC}$, $R_{AC}$ and $R_{DC0}$, the values of capacity and $R_{DC}$ at five different states of charge (SOC). Next, the capacity estimation models are adjusted, obtaining new parameters. In addition, the adaptation factors of $R_{DC0}$ are adjusted according to the new data. With all this, the capacity (C^) and the internal resistance and $R_{DC\_SOC}$ from the rest of the elements in the sample are estimated.

To check the accuracy of the proposed models, C^ and $R_{DC\_SOC}$ are determined according to the detailed characterisation, and it is compared with the result of the simplified estimation, determining the estimation error ($\delta i$) for the three models, according to Equation 4 previously explained. Specifically, the estimation errors for capacity (C^) and internal resistance ($R_{DC\_SOC}$) in Sample 1 and Sample 2 are considered.

It has been obtained that the accuracy of the estimation of capacity (C^) is similar in both samples 1 and 2. Specifically, the medians of the error are between 1.8% and 2.2% in Sample 1 and 2.5% in Sample 2. Regarding the dispersion of the error, it is worth noting the differences observed in Model 2, which shows the highest and lowest value, specifically 5.8% and 8.4%. This may be due, on the one hand, to the higher values of $R_{DC0}$ in Population 2 and, on the other, to the greater variation of the reception SOC observed in this sample. Regarding the estimate of $R_{DC-SOC}$, it is worth noting the difference in accuracy between Model 1, with medians between 2.5% and 3.6%, and the other two models, the medians of which range between 0.8% and 1.9% due to the lower correlation of $R_{AC}$ with $R_{DC\_SOC}$.

3.3.- Application of the method to battery modules

In this subsection, a further step is taken in the estimation of the capacity of second-life batteries, analysing another study level. For this, there is a Sample 3, made up of 203 modules (n3). The characterisation results of these modules are obtained from the experimental data of the cells that make them up, previously described in this section. In this way, the capacity of the module is considered as the lowest value of the pairs of cells, while the internal resistance is defined as the sum of both. Table 7 shows the statistical summary of the rapid characterisation measures for Population C, normalised with respect to the values of Table 3.

Table 7: Rapid characterisation results in Sample 3.

|         | $R_{AC}$ | $SOC_O$ (%) | $R_{DC0}$ |
|---------|----------|-------------|-----------|
| Mean    | 2.06     | 37.4        | 2.20      |
| Std     | 0.41     | 6.7         | 0.68      |
| Max     | 2.55     | 62.6        | 2.73      |
| Min     | 1.08     | 11.0        | 1.12      |
| CV (%)  | 15.73    | 18.0        | 15.85     |

Following the proposed rapid estimation methodology, the statistical test is first carried out to determine if Sample 3 belongs to any of the characterised populations (Population 0 or Population 1). Since none of the measured variables follows a normal distribution, the Kruskal-Wallis test is applied, which results in p-values of 0.00 in both variables. Therefore, it is concluded that these samples do not belong to the previous populations, something to be expected since they are modules instead of cells.

As described above, a subsample of size $n_s$ = 40 modules is fully characterised, and the estimation models are adjusted. With the new models, the capacity (C^) and internal resistance ($R_{DC\_SOC}$) in the rest of the elements of the sample are estimated, measuring both variables experimentally to verify the accuracy of the models. A study of the estimation error ($\delta i$) for (C^) and ($R_{DC\_SOC}$) for each model, based on Equation 4 indicated above, allows us to observe that the capacity estimation results (C^) are similar for the three models, with medians between 2.4 % and 2.6 %, the best result being that of Model 3. Model 3 also has the smallest extreme values. Regarding the estimation of $R_{DC\_SOC}$, large differences are observed between Model 1, with medians between 2.6% and 3.0%, and the rest, with values between 0.8% and 1.3%. Likewise, in Model 1 there are more extreme error values, above 11%, compared to values less than 6.1% in the other models. Considering the SOC, it can be seen how the worst estimation results are obtained for the extreme values.

3.4.- Rapid estimation of capacity in battery packs

Finally, there is a Sample 4 of 3 battery packs (D1, D2, D3). Since they are not enough to develop specific models, the capacity (C) and internal resistance ($R_{DC\_SOC}$) will be estimated from the models developed at the module level.

Thus, first of all, the voltage $V_{OC}$ of the three of them is measured, without anomalous values being detected. Next, an initial step current is performed, in order to measure the $R_{DC0}$. The available test bench, described in Section 3.3, does not allow the measurement of $R_{AC}$, since it exceeds the maximum voltage of the measuring device. Table 8 shows the measurements of the three packs.

Table 8: **Rapid** characterisation results in Sample 4.

| Battery pack | $SOC_0$ (%) | $R_{DC0}$ (mΩ) |
|---|---|---|
| D1 | 79.1 | 129.2 |
| D2 | 23.3 | 126.9 |
| D3 | 40.5 | 205.5 |

To estimate the capacity (C^) with the available data, Model 2 is used, dividing the value of $R_{DC0}$ between the number of modules that make up the battery pack, thus obtaining the equivalent resistance to be used in the model. Next, the capacity (C) and the internal resistance ($R_{DC\_SOC}$) are estimated following the methodology, and their real values are measured to know the estimation error. It is striking that, despite having lower capacity, the D1 battery pack has lower resistance, which may be due to the background of its first life, which affected power loss more than energy loss. Regarding estimation errors ($\delta2$) for capacity applying Model 2, it is observed that, with model 2, the capacity is estimated with a maximum error of 6.6%. The smallest estimation error is obtained in D3. The worst result is obtained for D1 wherein, as observed in the measurements performed, there is an anomalous relationship between capacity (C) and internal resistance ($R_{DC}$), with higher values of resistance and lower values of capacity than in D2.

Regarding estimation errors ($\delta_2$) for internal resistance applying Model 2, there is a similar median error in D2 and D3, around 2.4%. In the case of D2, the difference in the error at 10% SOC is striking, which in this battery pack is similar to the rest of the measurements at other SOCs, unlike the other battery packs, the difference in resistance at low SOC of which is more notable compared to the rest of values. In the three battery packs, the worst estimation result is at 10%, the same as in modules.

4.- ANALYSIS OF RESULTS

To assess the accuracy in the estimation achieved with each of the three models, a maximum estimation error ($\delta$) is established, which varies between 1 and 5%, so that an estimate is considered correct if the estimation error is below said limit. Evaluating the percentage of correct estimates, both for C and $R_{DC\_50}$, achieved by each model based on the value of $\delta$ in the four samples 1-4 analysed, it is observed that the best results correspond to Model 3, reaching a success in the capacity estimation of 95% in Samples 1 and 2 and of 92% in Sample 3, considering errors of less than 5% acceptable. For its part, Model 1 correctly estimates 88%, 87% and 85% of the data from Samples 3, 2 and 1 respectively. Model 2 yields the best results in Sample 1, with 90% success, compared to 88% in Sample 3, 84% in Sample 2, and 66% in Sample 4. Note that the capacity of Sample 4 can only be estimated using Model 2. The results are satisfactory in two of the three available battery packs, assuming an estimation error of 5%. This difference in accuracy in Sample 4 compared to the rest is justified by the lower number of elements (3 compared to 103 or 203), which entails a greater influence of the points, as well as the variability of the initial resistance measurement compared to the module-level results from which the model has been developed.

Moreover, regarding the accuracy results in the estimation of $R_{DC\_50}$ from Models 1-3 it can be seen how the accuracy of Model 1 is much lower than that of Models 2 and 3. Specifically, Model 1 allows estimating with an error of 5%, 71%, 64% and 70% in Samples 1, 2 and 3 respectively. In that same order referring to Samples 1, 2 and 3, Model 2 correctly estimates 98%, 90% and 97%, while Model 3 has 98%, 91% and 96% success. In the case of Sample 4, the internal resistance of 100% of the battery packs is estimated assuming an estimation error of 5%.

In addition to the accuracy of the proposed methodology, it is important to quantify the differences in test times used compared to traditional characterisation methods. Table 9 shows time and energy data from the traditional measurement methods and the proposed estimation method. The data correspond to the median of the cells tested in this contribution.

Table 9: Values of time and energy consumed, and equipment, in the characterisation by cell, in the traditional measurement method and in the estimation method proposed in the invention.

| | Traditional method | | Method of the invention | | |
|---|---|---|---|---|---|
| | Time (min) | Energy (Wh) | Time (min) | Energy (Wh) | Equipment |
| Capacity | 836 | 1071 | - | - | Cycler Thermal camera |

(continued)

| | Traditional method | | Method of the invention | | |
| --- | --- | --- | --- | --- | --- |
| | Time (min) | Energy (Wh) | Time (min) | Energy (Wh) | Equipment |
| $R_{DC\_SOC}$ | 606 | 357 | - | - | Cycler Thermal camera |
| $R_{DC0}$ | 1 | 1 | 1 | 1 | Cycler |
| $R_{AC}$ | 1 | - | 1 | - | Impedance meter |
| TOTAL | 1444 | 1429 | 2 | 1 | |

As can be seen, the method of the invention involves a drastic reduction in test times, going from more than one day for test to 2 minutes per cell. The decrease in the energy used is even more pronounced, going from 1429 Wh to 1 Wh. Regarding the required equipment, it is noteworthy that the measurement of $R_{DC0}$ in the rapid characterisation method can be performed without a thermal camera, since the low duration of the DC measurement pulse, of a few seconds, is not sufficient to significantly increase the internal temperature of the cells.

5.- CONCLUSIONS

In this preferred application, the rapid estimation of capacity and internal resistance methodology is applied to determine the characteristics of cells, modules or battery packs in test times of less than 2 minutes. This methodology is supported by experimental data from 506 cells, 203 modules and 3 battery packs from Nissan Leaf electric vehicles.

To carry out the application of the proposed methodology, 4 different samples are used, two of them made up of cells, one made up of modules and another of battery packs. The results obtained for the cells reach a median estimation error of less than 2.5% in capacity and 3.6% in internal resistance for both samples with Model 3. In relation to the sample of modules, with said model a median estimation error of less than 2.4% and 3% is obtained in the capacity and in the internal resistance, respectively. In the case of battery packs, the results show a maximum estimation error of 6.6% in capacity and 9.5% in internal resistance. Moreover, better estimation results are obtained with Model 3. Specifically, considering an estimation error of 5% acceptable, it is obtained that the capacity is correctly estimated in 95% of the cells and in 92% of the modules using Model 3. As for the estimation of DC resistance, Model 3 gives 97% correct estimates.

In addition, the number of samples to which a detailed characterisation must be carried out ($n_s$) has been analysed. The selection of said number of samples will depend on the accuracy and the desired test time. Specifically, for a capacity estimation error of 4%, it has been verified that from 40 samples hardly any improvements are achieved. However, by halving the number of samples, that is, reducing it to 20 samples, the correct estimates are reduced by 5 to 7.5% depending on the population of cells analysed.

In terms of test time and energy consumed to obtain capacity and resistance, savings of 99.86% in test time and 99.93% in energy have been quantified. In addition, the number of pieces of equipment required to carry out the tests is also reduced, such as, for example, the climatic chamber that controls the temperature in long-term characterisation tests. Consequently, this methodology manages to reduce the economic and time cost associated with the process of reusing second-life batteries and, specifically, the characterisation process.

**Claims**

1. A method for characterising a battery, the method comprising the following steps:

- obtaining one or more simplified characterisation parameters ($R_{AC}$, $R_{DC\_30}$) of the battery, through a simplified characterisation, which comprises at least one of the following steps:

- determining impedance ($R_{AC}$) of the battery at a predetermined frequency; and
- determining a discharge resistance ($R_{DC\_30}$) at a predetermined state of charge (SOC) value, which in turn comprises:

- measuring open-circuit voltage ($V_{OC}$) in the battery;
- determining a discharge resistance ($R_{DC0}$), subjecting the battery to a discharge step, with a discharge current, and during a discharge time, measuring current and voltage (I1, V1) before and after discharge (I2, V2), and calculating the discharge resistance ($R_{DC0}$) as $R_{DC0}$ = (V2-V1) / (I2-I1); and
- obtaining $R_{DC\_30}$ from $R_{DC0}$ and from $V_{OC}$, by means of various predetermined relationships, comprising first obtaining SOC from $V_{OC}$, then obtaining $R_{DC\_30}$ from SOC; and the method being **characterised in**

- obtaining an estimated value for capacity ($C^\wedge$), and for the components of an internal resistance vector ($R_{DC\_SOC}$) as a function of a state of charge vector (SOC), of the battery, from one or more of the simplified characterisation parameters ($R_{AC}$, $R_{DC\_30}$) according to one or more models, wherein each model contains an expression for the value of ($C^\wedge$) and another expression for ($R_{DC\_SOC}$), as a function of one or more of the simplified characterisation parameters ($R_{AC}$, $R_{DC0}$) and of previously determined model parameters ($C_{0\alpha}$, $\alpha_{1C}$, $\alpha_{2C}$, $R_{DC0\alpha}$, $\alpha_{1R}$, $C_{0\beta}$, $\beta_{1C}$, $\beta_{2C}$, $R_{DC0\beta}$, $\beta_{1R}$, $C_{0\gamma}$, $\gamma_{1C}$, $\gamma_{2C}$, $\gamma_{3C}$, $R_{DC0\gamma}$, $\gamma_{1R}$, $\gamma_{2R}$, $\gamma_{3R}$).

2. The method according to claim 1, wherein the model or models comprise at least one model based on only one simplified characterisation parameter ($R_{AC}$, $R_{DC\_30}$).

3. The method according to claim 2, wherein the model or models comprise a model 1 based solely on $R_{AC}$.

4. The method according to claim 2, wherein the model or models comprise a model 2 based solely on $R_{DC\_30}$.

5. The method according to any of claims 3-4, wherein, in model 1 or model 2, the expression for ($C^\wedge$) is quadratic, while the expression for ($R_{DC\_SOC}$) is linear, with respect to the only parameter on which the model is based, wherein for model 1,

$$C^\wedge = C_{0\alpha} + \alpha_{1,C} \cdot R_{AC} + \alpha_{2,C} \cdot (R_{AC})^2$$

and

$$R_{DC\_SOC} = R_{DC0\alpha} + \alpha_{1,R} \cdot R_{AC}$$

while, for model 2,

$$C^\wedge = C_{0\beta} + \beta_{1,C} \cdot R_{DC\_30} + \beta_{2,C} \cdot (R_{DC\_30})^2$$

and

$$R_{DC\_SOC} = R_{DC0\beta} + \beta_{1,R} \cdot R_{DC\_30}.$$

6. The method according to claim 1, **characterised in that** the model or models comprise a model 3 based on the two simplified characterisation parameters ($R_{AC}$, $R_{DC\_30}$).

7. The method according to claim 6, **characterised in that**, in model 3, the expression for ($C^\wedge$) and the expression for ($R_{DC\_SOC}$) are quadratic in $R_{AC}$ and linear in $R_{DC\_30}$, wherein, for model 3,

$$C^\wedge = C_{0\gamma} + \gamma_{1,C} \cdot R_{AC} + \gamma_{2,C} \cdot (R_{AC})^2 + \gamma_{3,C} \cdot R_{DC\_30}$$

and

$$R_{DC\_SOC} = R_{DC0\gamma} + \gamma_{1,R} \cdot R_{AC} + \gamma_{2,R} \cdot (R_{AC})^2 + \gamma_{3,R} \cdot R_{DC\_30}.$$

8. The method according to any of claims 1-7, further comprising a prior step of performing a detailed characterisation of a prior battery pack, to obtain detailed characterisation parameters ($C$, $R_{DC\_i}$, $R_{AC}$) and, from said detailed characterisation parameters ($C$, $R_{DC\_i}$, $R_{AC}$), obtaining the model parameters ($C_{0\alpha}$, $\alpha_{1C}$, $\alpha_{2C}$, $R_{DC0a}$, $\alpha_{1R}$, $C_{0\beta}$, $\beta_{1C}$, $\beta_{2C}$, $R_{DC0\beta}$, $\beta_{1R}$, $C_{0\gamma}$, $\gamma_{1C}$, $\gamma_{2C}$, $\gamma_{3C}$, $R_{DC0\gamma}$, $\gamma_{1R}$, $\gamma_{2R}$, $\gamma_{3R}$), and which comprises the steps of:

- Measuring discharge capacity ($C$) of each of the batteries of the previous battery pack; and
- Measuring a discharge resistance vector ($R_{DC\_i}$) at different levels of state of charge (SOC), indicated by subscript $i$ included between [0, 100%], for each of the batteries in the previous battery pack, which in turn comprises:

- subjecting each battery to a series of consecutive progressive discharges, between predetermined SOC values;
- measuring voltage (V2) and current (I2) after each discharge and also before each discharge (V1, I1), so that the value of $R_{DC\_i}$ is calculated as $R_{DC\_i}$ = (V2-V1) / (I2-I1), where $i$ refers to the state of charge at which the discharge begins;

wherein the expressions of the models relate (C^) and ($R_{DC\_SOC}$) with the simplified characterisation parameters $R_{DC0}$ and $R_{AC}$);
the method further comprising:

- for each model, adjusting the model parameters ($C_{0\alpha}$, $\alpha_{1C}$, $\alpha_{2C}$, $R_{DC0\alpha}$, $\alpha_{1R}$, $C_{0\beta}$, $\beta_{1C}$, $\beta_{2C}$, $R_{DC0\beta}$, $\beta_{1R}$, $C_{0\gamma}$, $\gamma_{1C}$, $\gamma_{2C}$, $\gamma_{3C}$, $R_{DC0\gamma}$, $\gamma_{1R}$, $\gamma_{2R}$, $\gamma_{3R}$), by substituting, in the expressions for (C^) and ($R_{DC\_SOC}$) of the model, the values of the detailed characterisation parameters (C, $R_{DC\_i}$, $R_{AC}$).

9. The method according to claim 8, wherein the detailed characterisation further comprises a step of determining an impedance ($R_{AC}$) of the batteries in the previous battery pack.

10. The method according to any of claims 8-9, further comprising:

- measuring open-circuit voltage ($V_{OC}$) of the batteries of the previous battery pack under charge and discharge conditions;
- determining FSOC - $V_{OC}$ relationships, using predetermined function types, from measurements of SOC and open-circuit voltage ($V_{OC}$).

11. The method according to claim 10, wherein the predetermined function that relates $V_{OC}$ with SOC is a polynomial P, such that a polynomial of order 5 (P5), wherein SOC = P($V_{OC}$), as well as another predetermined function is used to obtain FSOC based on SOC.

12. The method according to any of claims 8-11, wherein $R_{DC\_30}$ =FSOC * $R_{DC0}$.

13. The method according to any of claims 8-12, further comprising a statistical analysis to determine if the batteries to be characterised through the simplified characterisation are compatible with the models of the detailed characterisation of the previous battery pack, based on carrying out tests that compare the detailed characterisation parameters ($R_{DC\_i}$, $R_{AC}$) of the previous battery pack with the simplified characterisation parameters ($R_{AC}$, $R_{DC\_30}$) of the battery pack being characterised.

14. The method according to claim 13, comprising the additional step of applying, to the batteries of the battery pack to be characterised, the models of the previous batteries characterised using detailed characterisation, when the result of the test determines that both battery packs are compatible.

15. The method according to claim 13, comprising the additional step of applying the detailed characterisation to the battery pack to be characterised, when the result of the test determines that both battery packs are not compatible.

**Patentansprüche**

1. Verfahren zum Charakterisieren einer Batterie, wobei das Verfahren die folgenden Schritte umfasst:

- Erhalten eines oder mehrerer vereinfachter Charakterisierungsparameter ($R_{AC}$, $R_{DC\_30}$) der Batterie durch eine vereinfachte Charakterisierung, die mindestens einen der folgenden Schritte umfasst:

- Bestimmen der Impedanz ($R_{AC}$) der Batterie bei einer vorgegebenen Frequenz; und
- Bestimmen eines Entladewiderstands ($R_{DC\_30}$) bei einem vorbestimmten Wert des Ladezustands (SOC), was wiederum Folgendes umfasst:

- Messen der Leerlaufspannung ($V_{OC}$) in der Batterie;
- Bestimmen eines Entladewiderstands ($R_{DC0}$), wobei die Batterie einem Entladeschritt mit einem Entladestrom unterzogen wird und während einer Entladezeit Strom und Spannung (I1, V1) vor und nach der Entladung (I2, V2) gemessen werden, und Berechnen des Entladewiderstands ($R_{DC0}$) als $R_{DC0}$ = (V2-V1) / (I2-I1); und
- Erhalten von $R_{DC\_30}$ aus $R_{DC0}$ und aus $V_{OC}$, mittels verschiedener vorbestimmter Beziehungen, umfassend zuerst das Erhalten von SOC aus $V_{OC}$, dann das Erhalten von $R_{DC\_30}$ aus SOC; und wobei das Verfahren durch Folgendes gekennzeichnet ist:

- Erhalten eines geschätzten Wertes für die Kapazität (C^) und für die Komponenten eines Innenwiderstandsvektors ($R_{DC\_SOC}$) als eine Funktion eines Vektors des Ladezustands (SOC) der Batterie aus einem oder mehreren der vereinfachten Charakterisierungsparameter ($R_{AC}$, $R_{DC\_30}$) nach einem oder mehreren Modellen, wobei jedes Modell einen Ausdruck für den Wert von (C^) und einen weiteren Ausdruck für ($R_{DC\_SOC}$) enthält, als eine Funktion eines oder mehrerer der vereinfachten Charakterisierungsparameter ($R_{AC}$, $R_{DC0}$) und der zuvor bestimmten Modellparameter ($C_{0\alpha}$, $\alpha_{1C}$, $\alpha_{2C}$, $R_{DC0\alpha}$, $\alpha_{1R}$, $C_{0\beta}$, $\beta_{1C}$, $\beta_{2C}$, $R_{DC0\beta}$, $\beta_{1R}$, $C_{0\gamma}$, $\gamma_{1C}$, Y2C, $\gamma_{3C}$, $R_{DC0\gamma}$, $\gamma_{1R}$, $\gamma_{2R}$, $\gamma_{3R}$).

2. Verfahren nach Anspruch 1, wobei das Modell oder die Modelle mindestens ein Modell umfassen, das auf nur einem vereinfachten Charakterisierungsparameter ($R_{AC}$,$R_{DC\_30}$) basiert.

3. Verfahren nach Anspruch 2, wobei das Modell oder die Modelle ein Modell 1 umfassen, das ausschließlich auf $R_{AC}$ basiert.

4. Verfahren nach Anspruch 2, wobei das Modell oder die Modelle ein Modell 2 umfassen, das ausschließlich auf $R_{DC\_30}$ basiert.

5. Verfahren nach einem der Ansprüche 3-4, wobei in Modell 1 oder Modell 2 der Ausdruck für (C^) quadratisch ist, während der Ausdruck für ($R_{DC\_SOC}$) linear ist, in Bezug auf den einzigen Parameter, auf dem das Modell basiert, wobei für Modell 1,

$$C^\wedge = C_{0\alpha} + \alpha_{1,c} \cdot R_{AC} + \alpha_{2,c} \cdot (R_{AC})^2$$

und

$$R_{DC\_SOC} = R_{DC0\alpha} + \alpha_{1,R} \cdot R_{AC}$$

während bei Modell 2,

$$C^\wedge = C_{0\beta} + \beta_{1,c} \cdot R_{DC\_30} + \beta_{2,c} \cdot (R_{DC\_30})^2$$

und

$$R_{DC\_SOC} = R_{DC0\beta} + \beta_{1,R} \cdot R_{DC\_30}.$$

6. Verfahren nach Anspruch 1, **dadurch gekennzeichnet, dass** das Modell oder die Modelle ein Modell 3 basierend auf den beiden vereinfachten Charakterisierungsparametern ($R_{AC}$,$R_{DC\_30}$) umfassen.

7. Verfahren nach Anspruch 6, **dadurch gekennzeichnet, dass** bei Modell 3 der Ausdruck für (C^) und der Ausdruck für ($R_{DC\_SOC}$) quadratisch in $R_{AC}$ und linear in $R_{DC\_30}$ sind, wobei bei Modell 3,

$$C^\wedge = C_{0\gamma} + \gamma_{1,c} \cdot R_{AC} + \gamma_{2,c} \cdot (R_{AC})^2 + \gamma_{3,c} \cdot R_{DC\_30}$$

und

$$R_{DC\_SOC} = R_{DC0\gamma} + \gamma_{1,R} \cdot R_{AC} + \gamma_{2,R} \cdot (R_{AC})^2 + \gamma_{3,R} \cdot R_{DC\_30}.$$

8. Verfahren nach einem der Ansprüche 1-7, ferner umfassend einen vorherigen Schritt des Durchführens einer detaillierten Charakterisierung eines vorherigen Batteriepacks, um detaillierte Charakterisierungsparameter (C, $R_{DC\_i}$, $R_{AC}$) zu erhalten, und, aus den detaillierten Charakterisierungsparametern (C, $R_{DC\_i}$, $R_{AC}$) die Modellparameter ($C_{0\alpha}$, $\alpha_{1C}$, $\alpha_{2C}$, $R_{DC0\alpha}$, $\alpha_{1R}$, $C_{0\beta}$, $\beta_{1C}$, $\beta_{2C}$, $R_{DC0\beta}$, $\beta_{1R}$, $C_{0\gamma}$, $\gamma_{1C}$, $\gamma_{2C}$, $\gamma_{3C}$, $R_{DC0\gamma}$, $\gamma_{1R}$, $\gamma_{2R}$, $\gamma_{3R}$) zu erhalten, und das die folgenden Schritte umfasst:

- Messen der Entladekapazität (C) der einzelnen Batterien des vorherigen Batteriepacks; und
- Messen eines Vektors des Entladewiderstands ($R_{DC\_i}$) bei verschiedenen Niveaus des Ladezustands (SOC), angegeben durch das tiefgestellte i, das zwischen [0, 100 %] enthalten ist, für jede der Batterien des vorherigen Batteriepacks, was wiederum Folgendes umfasst:

- Unterziehen jeder Batterie einer Reihe von aufeinanderfolgenden progressiven Entladungen zwischen vorbestimmten SOC-Werten;
- Messen der Spannung (V2) und des Stroms (I2) nach jeder Entladung und auch vor jeder Entladung (V1,11), sodass der Wert von $R_{DC\_}$ als $R_{DC\_i}$ = (V2-V1) / (I2-I1) berechnet wird, wobei sich i auf den Ladezustand bezieht, bei dem die Entladung beginnt;

wobei die Ausdrücke der Modelle (C^) und ($R_{DC\_SOC}$) mit den vereinfachten Charakterisierungsparametern $R_{DC0}$ und $R_{AC}$) in Beziehung stehen;
wobei das Verfahren ferner Folgendes umfasst:

- für jedes Modell, Einstellen der Modellparameter ($C_{0\alpha}$, $\alpha_{1C}$, $\alpha_{2C}$, $R_{DC0\alpha}$, $\alpha_{1R}$, $C_{0\beta}$, $\beta_{1C}$, $\beta_{2C}$, $R_{DC0\beta}$, $\beta_{1R}$, $C_{0\gamma}$, $\gamma_{1C}$, $\gamma_{2C}$, $\gamma_{3C}$, $R_{DC0\gamma}$, $\gamma_{1R}$, $\gamma_{2R}$, $\gamma_{3R}$), indem in den Ausdrücken für (C^) und ($R_{DC\_SOC}$) des Modells die Werte der detaillierten Charakterisierungsparameter (C, $R_{DC\_i}$, $R_{AC}$) ersetzt werden.

9. Verfahren nach Anspruch 8, wobei die detaillierte Charakterisierung ferner einen Schritt des Bestimmens einer Impedanz ($R_{AC}$) der Batterien in dem vorherigen Batteriepack umfasst.

10. Verfahren nach einem der Ansprüche 8-9, ferner umfassend:

- Messen der Leerlaufspannung ($V_{OC}$) der Batterien des vorherigen Batteriepacks unter Lade- und Entladebedingungen;
- Bestimmen von FSOC-$V_{OC}$-Beziehungen unter Verwendung vorbestimmter Funktionstypen aus Messungen von SOC und Leerlaufspannung ($V_{OC}$).

11. Verfahren nach Anspruch 10, wobei die vorbestimmte Funktion, die $V_{OC}$ mit SOC in Beziehung setzt, ein Polynom P ist, sodass ein Polynom der Ordnung 5 (P5), wobei SOC = P($V_{OC}$), sowie eine andere vorbestimmte Funktion verwendet wird, um FSOC basierend auf SOC zu erhalten.

12. Verfahren nach einem der Ansprüche 8-11, wobei $R_{DC\_30}$ = FSOC * $R_{DC0}$.

13. Verfahren nach einem der Ansprüche 8-12, ferner umfassend eine statistische Analyse, um zu bestimmen, ob die durch die vereinfachte Charakterisierung zu charakterisierenden Batterien mit den Modellen der detaillierten Charakterisierung des vorherigen Batteriepacks kompatibel sind, basierend auf dem Durchführen von Tests, die die detaillierten Charakterisierungsparameter ($R_{DC\_i}$ $R_{AC}$) des vorherigen Batteriepacks mit den vereinfachten Charakterisierungsparametern ($R_{AC}$, $R_{DC\_30}$) des Batteriepacks vergleichen, das charakterisiert wird.

14. Verfahren nach Anspruch 13, umfassend den zusätzlichen Schritt des Anwendens, auf die Batterien des zu charakterisierenden Batteriepacks, der Modelle der vorherigen Batterien, die unter Verwendung der detaillierten Charakterisierung charakterisiert werden, wenn das Ergebnis des Tests bestimmt, dass die beiden Batteriepacks kompatibel sind.

15. Verfahren nach Anspruch 13, umfassend den zusätzlichen Schritt des Anwendens der detaillierten Charakterisierung auf das zu charakterisierende Batteriepack, wenn das Ergebnis des Tests bestimmt, dass beide Batteriepacks nicht kompatibel sind.

**Revendications**

1. Procédé de caractérisation d'une batterie, le procédé comprenant les étapes suivantes :

   - obtention d'un ou plusieurs paramètres de caractérisation simplifiés ($R_{AC}$, $R_{DC\_30}$) de la batterie, par le biais d'une caractérisation simplifiée, qui comprend au moins l'une des étapes suivantes :

      - détermination de l'impédance (Rac) de la batterie à une fréquence prédéterminée ; et
      - détermination d'une résistance à la décharge ($R_{DC\_30}$) à une valeur d'état de charge (SOC) prédéterminée, qui comprend à son tour :

         - la mesure de tension en circuit ouvert ($V_{OC}$) dans la batterie ;
         - la détermination d'une résistance de décharge ($R_{DC0}$), la soumission de la batterie à une étape de décharge, avec un courant de décharge, et pendant un temps de décharge, la mesure de courant et de tension (I1, V1) avant et après la décharge (I2, V2), et le calcul de la résistance de décharge ($R_{DC0}$) comme $R_{DC0}$ = (V2-V1) / (I2-I1) ; et
         - l'obtention de $R_{DC\_30}$ à partir de $R_{DC0}$ et de $V_{OC}$, au moyen de diverses relations prédéterminées, comprenant d'abord l'obtention de SOC à partir de $V_{OC}$, puis l'obtention de $R_{DC\_30}$ à partir de SOC ; et le procédé étant **caractérisé par**

   - l'obtention d'une valeur estimée pour la capacité (C^) et pour les composantes d'un vecteur de résistance interne ($R_{DC\_SOC}$) en fonction d'un vecteur d'état de charge (SOC), de la batterie, à partir d'un ou plusieurs des paramètres de caractérisation simplifiés ($R_{AC}$, $R_{DC\_30}$) selon un ou plusieurs modèles, dans lequel chaque modèle contient une expression pour la valeur de (C^) et une autre expression pour ($R_{DC\_SOC}$), en fonction d'un ou plusieurs des paramètres de caractérisation simplifiés ($R_{AC}$, $R_{DC0}$) et des paramètres de modèle précédemment déterminés ($C_{0\alpha}$, $\alpha_{1C}$, $\alpha_{2C}$, $R_{DC0\alpha}$, $\alpha_{1R}$, $C_{0\beta}$, $\beta_{1C}$, $\beta_{2C}$, $R_{DC0\beta}$, $\beta_{1R}$, $C_{0\gamma}$, $\gamma_{1C}$, $\gamma_{2C}$, $\gamma_{3C}$, $R_{DC0\gamma}$, $\gamma_{1R}$, $\gamma_{2R}$, $\gamma_{3R}$).

2. Procédé selon la revendication 1, dans lequel le modèle ou les modèles comprennent au moins un modèle basé sur un seul paramètre de caractérisation simplifié ($R_{AC}$, $R_{DC\_30}$).

3. Procédé selon la revendication 2, dans lequel le modèle ou les modèles comprennent un modèle 1 basé exclusivement sur $R_{AC}$.

4. Procédé selon la revendication 2, dans lequel le modèle ou les modèles comprennent un modèle 2 basé exclusivement sur $R_{DC\_30}$.

5. Procédé selon l'une quelconque des revendications 3 à 4, dans lequel, dans le modèle 1 ou le modèle 2, l'expression de (C^) est quadratique, alors que l'expression de ($R_{DC\_SOC}$) est linéaire, par rapport au seul paramètre sur lequel le modèle est basé, dans lequel

   pour le modèle 1,

$$C\text{^} = C_{0\alpha} + \alpha_{1,C} \cdot R_{AC} + \alpha_{2,C} \cdot (R_{AC})^2$$

   et

$$R_{DC\_SOC} = R_{DC0\alpha} + \alpha_{1,R} \cdot R_{AC}$$

   tandis que, pour le modèle 2,

$$C\text{^} = C_{0\beta} + \beta_{1,C} \cdot R_{DC\_30} + \beta_{2,C} \cdot (R_{DC\_30})^2$$

   et

$$R_{DC\_SOC} = R_{DC0\beta} + \beta_{1,R} \cdot R_{DC\_30}.$$

**6.** Procédé selon la revendication 1, **caractérisé en ce que** le modèle ou les modèles comprennent un modèle 3 basé sur les deux paramètres de caractérisation simplifiés ($R_{AC}$, $R_{DC\_30}$).

**7.** Procédé selon la revendication 6, **caractérisé en ce que**, dans le modèle 3, l'expression de (C^) et l'expression de ($R_{DC\_SOC}$) sont quadratiques dans $R_{AC}$ et linéaires dans $R_{DC\_30}$, dans lequel, pour le modèle 3,

$$C^\wedge = C_{0\gamma} + \gamma_{1,C} \cdot R_{AC} + \gamma_{2,C} \cdot (R_{AC})^2 + \gamma_{3,C} \cdot R_{DC\_30}$$

et

$$R_{DC\_SOC} = R_{DC0\gamma} + \gamma_{1,R} \cdot R_{AC} + \gamma_{2,R} \cdot (R_{AC})^2 + \gamma_{3,R} \cdot R_{DC\_30}.$$

**8.** Procédé selon l'une quelconque des revendications 1 à 7, comprenant en outre une étape antérieure de caractérisation détaillée d'un bloc-batterie antérieur, pour obtenir des paramètres de caractérisation détaillés (C, $R_{DC\_i}$, $R_{AC}$) et, à partir desdits paramètres de caractérisation détaillés (C, $R_{DC\_i}$, $R_{AC}$), l'obtention des paramètres de modèle ($C_{0\alpha}$, $\alpha_{1C}$, $\alpha_{2C}$, $R_{DC0\alpha}$, $\alpha_{1R}$, $C_{0\beta}$, $\beta_{1C}$, $\beta_{2C}$, $R_{DC0\beta}$, $\beta_{1R}$, $C_{0\gamma}$, $\gamma_{1C}$, $\gamma_{2C}$, $\gamma_{3C}$, $R_{DC0\gamma}$, $\gamma_{1R}$, $\gamma_{2R}$, $\gamma_{3R}$), et qui comprend les étapes consistant à :

- mesurer la capacité de décharge (C) de chacune des batteries du bloc-batterie précédent ; et
- mesurer un vecteur de résistance de décharge ($R_{DC\_i}$) à différents niveaux d'état de charge (SOC), indiqués par l'indice *i* compris entre [0, 100 %], pour chacune des batteries du bloc-batterie précédent, qui comprend à son tour :

- la soumission de chaque batterie à une série de décharges progressives consécutives, entre des valeurs SOC prédéterminées ;
- la mesure de tension (V2) et de courant (I2) après chaque décharge et également avant chaque décharge (V1,I1), de sorte que la valeur de $R_{DC\_i}$ est calculée comme $R_{DC\_i}$ = (V2-V1) / (I2-I1), où *i* fait référence à l'état de charge auquel la décharge commence ;

dans lequel les expressions des modèles mettent en relation (C^) et ($R_{DC\_SOC}$) avec les paramètres de caractérisation simplifiés $R_{DC0}$ et $R_{AC}$) ;
le procédé comprenant en outre :

- pour chaque modèle, l'ajustement des paramètres de modèle ($C_{0\alpha}$, $\alpha_{1C}$, $\alpha_{2C}$, $R_{DC0\alpha}$, $\alpha_{1R}$, $C_{0\beta}$, $\beta_{1C}$, $\beta_{2C}$, $R_{DC0\beta}$, $\beta_{1R}$, $C_{0\gamma}$, $\gamma_{1C}$, $\gamma_{2C}$, $\gamma_{3C}$, $R_{DC0\gamma}$, $\gamma_{1R}$, $\gamma_{2R}$, $\gamma_{3R}$), par substitution, dans les expressions de (C^) et ($R_{DC\_SOC}$) du modèle, des valeurs des paramètres de caractérisation détaillés (C, $R_{DC\_i}$, $R_{AC}$).

**9.** Procédé selon la revendication 8, dans lequel la caractérisation détaillée comprend en outre une étape consistant à déterminer une impédance ($R_{AC}$) des batteries du bloc-batterie précédent.

**10.** Procédé selon l'une quelconque des revendications 8 à 9, comprenant en outre :

- la mesure de tension en circuit ouvert ($V_{OC}$) des batteries du bloc-batterie précédent dans des conditions de charge et de décharge ;
- la détermination de relations FSOC - $V_{OC}$, à l'aide de types de fonctions prédéterminés, à partir des mesures du SOC et de tension en circuit ouvert ($V_{OC}$).

**11.** Procédé selon la revendication 10, dans lequel la fonction prédéterminée qui met en relation Voc avec SOC est un polynôme P, tel qu'un polynôme d'ordre 5 (P5), dans lequel SOC = P($V_{OC}$), ainsi qu'une autre fonction prédéterminée est utilisée pour obtenir le FSOC sur la base du SOC.

**12.** Procédé selon l'une quelconque des revendications 8 à 11, dans lequel $R_{DC\_30}$ = FSOC * $R_{DC0}$.

**13.** Procédé selon l'une quelconque des revendications 8 à 12, comprenant en outre une analyse statistique pour déterminer si les batteries à caractériser par le biais de la caractérisation simplifiée sont compatibles avec les modèles de la caractérisation détaillée du bloc-batterie précédent, sur la base de réalisation d'essais qui comparent les paramètres de caractérisation détaillés ($R_{DC\_i}$ $R_{AC}$) du bloc-batterie précédent avec les paramètres de caractérisation simplifiés ($R_{AC}$, $R_{DC\_30}$) du bloc-batterie en cours de caractérisation.

14. Procédé selon la revendication 13, comprenant l'étape supplémentaire consistant à appliquer, aux batteries du bloc-batterie à caractériser, les modèles des batteries précédentes caractérisés à l'aide d'une caractérisation détaillée, lorsque le résultat de l'essai détermine que les deux blocs-batteries sont compatibles.

15. Procédé selon la revendication 13, comprenant l'étape supplémentaire consistant à appliquer la caractérisation détaillée au bloc-batterie à caractériser, lorsque le résultat de l'essai détermine que les deux blocs-batteries ne sont pas compatibles.

Reception of a
battery batch

Rapid
characterisation
of $n_s$ batteries
(see FIG. 3)

Statistical
comparative analysis
(see FIG. 2)

Database for
characteristics of
populations

Sample similar
to any in the database?

NO

Detailed characterisation
of the $n_s$ batteries
(see FIG. 4)

YES

Proceed with rapid
characterisation
of the batch
(see FIG. 3)

# FIG. 1

FIG. 2

| Measuring open-circuit voltage $(V_{OC})$ | Impedance measurement $(R_{DC0})$ | Impedance measurement $(R_{AC})$ |

Calculation of $SOC$
from $V_{OC}$
(polynomial adjustment
of order 5)

Selection of FSOC
from $SOC$
(linear interpolation)

Calculation of $R_{DC\_30}$
$(R_{DC\_30} = FSOC \cdot R_{DC0})$

Selection of the desired estimation model

| Application of Model 2 | Application of Model 3 | Application of Model 1 |

Estimated values
of $C$ and $R_{DC}(SOC)$

FIG. 3

FIG. 4

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Performance model for high-power lithium titanate oxide batteries based on extended characterization tests. **STROE ANA-IRINA et al.** 2015 IEEE ENERGY CONVERSION CONGRESS AND EXPOSITION (ECCE). IEEE, 20 September 2015, 6191-6198